# EUROPEAN PATENT SPECIFICATION

(11) **EP 3 579 326 B1**
(45) Date of publication and mention of the grant of the patent: **23.08.2023**
(21) Application number: 18176228.7
(22) Date of filing: 06.06.2018
(51) Int. Cl.: H01M 10/42, H01M 10/48, H01M 10/6565

(54) **DETECTING ABNORMAL BATTERY SYSTEM CONDITIONS**
ERKENNUNG ABNORMALER BATTERIESYSTEMBEDINGUNGEN
DÉTECTION DE CONDITIONS ANORMALES D'UN SYSTÈME DE BATTERIE

(43) Date of publication of application: 11.12.2019
(73) Proprietor: Samsung SDI Co., Ltd., Gyeonggi-do 17084 (KR)
(72) Inventor: Golubkov, Andrej, 8010 Graz (AT)
(74) Representative: Gulde & Partner

(56) References cited:
- EP-A1- 2 797 158
- US-A1- 2011 260 731
- US-A1- 2012 085 109

## Description

### Field of the Invention

The present invention relates to a battery system, and particularly to a battery system comprising elements that allow for detecting an abnormal condition of the battery system. The present invention further relates to a method for detection an abnormal condition of such battery system, particularly of the battery cells and a high current path of the battery system, and preferably also of a low voltage path of the battery system. The invention further relates to a vehicle comprising the battery system of the present invention.

### Technological Background

A rechargeable or secondary battery differs from a primary battery in that it can be repeatedly charged and discharged, while the latter provides only irreversible conversion of chemical energy to electrical energy. Low-capacity rechargeable batteries are used as power supplies for small electronic devices, such as cellular phones, tablets, or notebook computers, while high-capacity rechargeable batteries are used as power supplies for vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

Battery modules can be constructed either in block design or in modular design. In block designs each battery is coupled to a common current collector structure and a common battery management system and the unit thereof is arranged in a housing. In modular designs, pluralities of battery cells are connected to form submodules and several submodules are connected to form the battery module. In automotive applications, battery systems often consist of a plurality of battery modules connected in series for providing a desired voltage. Therein, the battery modules may comprise submodules with a plurality of stacked battery cells, each stack comprising cells connected in parallel that are connected in series *(XpYs)* or multiple cells connected in series that are connected in parallel *(XsYp).*

For meeting the dynamic power demands of various electrical consumers connected to the battery system, static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers. Therefore, battery systems usually comprise a battery management system, BMS, for obtaining and processing such information on system level and further a plurality of cell supervision circuits, CSCs, which are part of the system's battery modules and obtain and process relevant information on system level. Particularly, the BMS usually measures the system voltage, the system current, the local temperature at different places inside the system housing, and the insulation resistance between live components and the system housing. Additionally, the CSCs usually measure individual the cell voltages and the temperatures of the battery modules.

The mechanical integration of such battery system requires appropriate mechanical connection of the individual battery system components among themselves and with structures of the electrical consumers, e.g. a vehicle. These connections must be designed to remain functional and safe during the average service life of the battery system and under the stresses provided during use of the consumers. Further, installation space, interchangeability and safety requirements must be met, especially in mobile applications. Safety requirements, including the protection of passengers of a vehicle of harmful effluents of the battery system, such as toxic gases, smoke, or the like, are usually provided by a gas tight housing enclosing the battery modules and BMS for restricting the emission of such effluents.

However, while the system housing may protect the passengers from harmful fumes it complicates detection of critical states of the battery system that may lead to a catastrophic event, e.g. an explosion of the battery system. Such catastrophic events may be caused by abnormal states like hot spots or corrosion. So far, the BMS could detect abnormal states based only on the acquired measurements regarding e.g. voltage, current and temperature. Hence, abnormal states which do not change the voltage, current, temperature or electrical insulation value have not been detectable. Exemplarily, such abnormal states can be due to electrolyte leakage, partial coolant intrusion, water intrusion, hot spots, smoldering insulation material and cables (pyrolysis, fire), moisture, condensation, corrosion, or electric arcing.

The inside of battery packs is usually not subject to periodic visual inspections and hence the detection of abnormal operation states via the BMS has been the only option for detecting such states. Hence according to the prior art, corrosion, water intrusion, or deteriorating electric contacts may stay undetected until a catastrophic event actually occurs.

US 2012/085109 A1 discloses an uninterruptible power supply system housed within a container and comprising a battery subsystem, a HVAC unit and an H2 detection system for detecting H2 within the container. US 2011/260731 A1 discloses a battery module with a plurality of batteries disposed in a fluid-tight housing with an inlet and with an outlet for the flow of a tempering fluid and a gas sensor for detecting certain gases in the tempering fluid.

It is thus an object of the present invention to overcome or reduce at least some of the drawbacks of the prior art and to provide a battery system that allows for an improved detection of abnormal states of the battery system, particularly of such abnormal states that do not alter the voltage, current, or temperature of the battery system.

### Description of the invention

According to the present invention a battery system is provided, that overcomes or reduced at least some of the disadvantages of the prior art and that comprises at least one battery module, which is interconnected between a first system terminal and a second system terminal by a plurality of high current connectors, and that further comprises a housing with a plurality of exterior walls enclosing the at least one battery module and the plurality of high current connectors and with at least one partition wall arranged within the housing.

According to the present invention, a flow channel loop is formed within the housing by the at least one partition wall and the exterior walls. Therein, the flow channel loop refers to a flow channel that does not end in a gas inlet or a gas outlet but that forms a closed loop allowing for a controlled gas flow circulation, particularly for a spatially confined gas flow circulation, within the battery system housing. According to the present invention, a gas conveyor that is configured for providing a gas flow circulation through the flow channel loop is arranged (disposed) in the flow channel loop. In other words, the gas conveyor is configured for effecting a circulation of gas, e.g. air, present in the housing to circulate in the flow channel loop in a circulatory manner. Further, at least one gas sensor that is configured for detecting an excess concentration, preferably a predetermined or learned excess concentration, of at least one gas species in the gas flow circulation is arranged in the flow channel loop. Further, the plurality of high current connectors and the at least one battery module constitute a high current path between the first and second system terminal that runs in parallel to the gas flow circulation. Thus, the gas flow circulation follows the high current path.

According to the present invention all components of the battery system that may cause a catastrophic event (if in an abnormal condition) are positioned within the flow channel loop. Hence, by analyzing a gas stream circulating in the flow channel loop for excess gas concentrations of at least one gas species indicative for an abnormal condition, an abnormal condition is reliably detected for all components of the battery system. Preferably, the gas circulating inside the housing passes at least all high current connectors and all battery cells disposed within the housing and hence none of them is left unconsidered as the gas flow circulation will pick up any gas release from these critical components and transport it to the at least one gas sensor. Abnormal conditions of the battery system are thus reliably detected. An additional benefit of the forced gas flow circulation is that the whole inside of the battery system housing is vented and the condensation of water vapor at cold spots is thus inhibited.

Preferably, the at least one battery module, preferably a plurality of battery modules, and the plurality of high current connectors are arranged entirely within the flow channel loop. In other words, the orientation and positions of these critical components and the dimensions of the flow channel loop are chosen such that none of these critical components are disposed within flow shade regions of the flow channel loop. Hence, by arranging the at least one battery module and the plurality of high current connectors entirely within the flow channel loop; these components are also arranged entirely within the gas flow circulation. In other words, preferably the gas flow circulation circulates around the entire at least one battery module, the entire plurality of high current connectors and the at least one gas sensor.

Preferably, the housing of the battery system is essentially gastight. In this embodiment, the housing may further comprise a pressure equalization filter disposed in one of the exterior walls of the housing for allowing a limited gas exchange with the environment. Hence, overpressure in the battery system housing may be reliably prevented. In this case, the gas flow circulation, except the emitted gases indicative for an abnormal condition, may be an airflow within the housing. Further preferred, the exterior walls and the at least one partition wall of the housing are essentially gastight. Particularly preferred, the housing, i.e. the exterior walls and the at least one partition wall, is formed of aluminum, such as e.g. casted aluminum. However plastic materials may also be used. The housing may be assembled from several parts, such as a bottom part comprising the exterior walls and the partition walls forming cell compartments and a top cover for covering the bottom part. The housing may further comprise sealing elements for providing controlled gas tightness to the environment.

According to a particularly preferred embodiment of the battery system, the flow channel loop comprises at least one cell compartment that is configured for receiving at least one battery module. Further preferred, the flow channel loop comprises an additional compartment that is configured for receiving at least one of the gas conveyor and the at least one gas sensor. By providing at least one cell compartment, it can be more easily ensured that the gas flow circulation actually runs over all of the critical components of the battery system. Particularly preferred, the volume of the at least one cell compartment is adapted to the volume of the at least one battery module disposed therein. Exemplarily, the volume of the cell compartment is not greater than 150%, preferred not greater than 130%, and particularly preferred not greater than 120% of the at least one battery module therein.

Exemplarily, for a plurality of battery cells stacked together in a stacking direction with their wide side surfaces facing each other for forming a longitudinal battery module, the length of the cell compartment may be essentially equal, e.g. not more than 105%, of the length of the battery module, the width of the cell compartment may be essentially equal, e.g. not more than 105%, of width of the wide side surfaces of the battery cells, and the height of the cell compartment may be slightly greater than, e.g. up to 110 % of, the height of the battery module. In such cell compartments the gas flow circulation is mainly constricted to a volume above the upper side of battery module that may comprise all of the high current connectors between the cells and hence any flow paths bypassing the battery module can be prevented.

Further preferred, at least one battery module, particularly preferred exactly one battery module, is disposed within each cell compartment with one of a first and second module terminal proximate to a gas inlet of the cell compartment and another one of the first and second module terminal proximate to a gas outlet of the cell compartment. This arrangement advantageously allows for an easy interconnection of battery modules disposed in adjacent cell compartments. This arrangement further eases to provide a gas flow circulation above the entire battery module, as the first (positive) module terminal will usually be arranged at first terminal end of the battery module and the second (negative) module terminal will usually be arranged at a second terminal end of the battery module opposite to the first terminal end.

According to this preferred embodiment, a single one of the at least one cell compartments is fluidly connected to a gas outlet of an adjacent cell compartment or to the additional compartment via its gas inlet and is fluidly connected to a gas inlet of an adjacent cell compartment or to the additional compartment via its gas outlet. Further preferred, the cell compartments may be essentially gastight except for the gas inlets and gas outlets. Hence, by restricting the size of the gas inlets and gas outlets and by controlling the positions of the gas inlets and outlets the gas flow circulation may be controlled. According to such preferred embodiment, a plurality of cell compartments may be arranged next to each other on a single level. However, cell compartments may also be stacked above each other in multiple levels.

Further preferred, the gas conveyor is a fan. However, other gas conveying means, such as pumps or compressors, can be utilized as well. Advantageously, the gas flow circulation can be conveyed by a rather small fan. The utilized fan preferably comprises a rather long service life (life time), particularly preferred a common service life of at least ten years. A gas flow cycle time is the time which a particle would need to make a full cycle, starting at the at least one gas sensor, going through the whole battery system along the flow channel loop and arriving again at the at least one sensor array. The gas flow cycling time together with the response time of the at least one sensor array define the reaction time of the battery system of the present invention to an abnormal condition occurring in the battery system. Therein, a more powerful fan will decrease the gas flow cycle time and the reaction time of the battery system.

According to a particularly preferred embodiment, the battery system may comprise a gas sensor array with a plurality of gas sensors disposed within the flow channel loop, wherein each gas sensor is configured for detecting a concentration of at least one gas species in the gas flow circulation. Usually, different abnormal conditions of a battery system will result in the release of different gas species at different temperatures and with different gas release rates inside the housing of the battery system. By providing a gas sensor array, preferably each of these gases can be detected in the range of the respective gas concentration to be expected and hence different failure types or abnormal conditions can be reliably detected. This may further allow for effecting specific countermeasures based on the kind of detected abnormal condition. Also preferred, the gas sensor array comprises multiple gas sensors with complementary detection methods for one gas species for increasing the detection reliability.

Particularly preferred, the gas sensor array comprises sensors capable of detecting at least the concentrations of the following gases or gases of the following gas species: carbon dioxide, carbon monoxide, hydrogen, oxygen, NOₓ, ozone, water vapor, and hydrocarbons (e.g. methane). The gas sensor array may further comprise a smoke detector, which actually is a particle detector. Each of these sensors may utilize a different measurement principle. Further preferred, multiple gas sensors for the same gas or gas species may be present in the gas sensor array, each of the multiple gas sensors using a complementary measurement principle for enhancing the measurement effectivity of the gas sensor array.

According to a preferred embodiment, the battery system comprises a battery management system, BMS, that is connected to the at least one gas sensor. Usually, the BMS is configured to monitor the whole battery system, e.g. by measuring system voltage, system current, local temperature at different places inside the system housing, and the insulation resistance between live components and the housing. According to the present invention, the at least one gas sensor is configured for transmitting at least one control signal to the BMS in response to detecting the excess concentration of at least one gas species in the gas flow circulation. The BMS is then configured for processing the at least one control signal and to detect abnormal conditions of the battery system based on the at least control signal. Particularly preferred the BMS is configured for determining the presence of one or more of a plurality of abnormal conditions of the battery system in response to receiving one or more control signals of the gas sensor array. Therein, the BMS may determine different abnormal conditions of the battery system based on respective different received control signals. Further preferred the BMS comprises a data interface to an exterior of the battery system that is configured for transmitting error codes or a battery status to external control devices. Therein, an error code or battery status may be related to an abnormal system condition.

Further preferred, the BMS is configured to perform at least one countermeasure in response to the received at least one control signal and/or in response to the determination of at least one abnormal condition of the battery system. Particularly, the BMS may be configured to control to: disconnect at least one of the first system terminal and the second terminal from the at least one battery module; switch to an emergency mode of the battery system; transmit a notification to a user of the battery system; increase cooling of the battery system; reduce emitted power of the battery system; and/or trigger a fire extinguisher for the battery system.

According to a particularly preferred embodiment, the battery system further comprises a battery disconnect unit, BDU, that is interconnected between at least one of the first and second system terminal and the at least one battery module. According to this embodiment, the BMS is configured for transmitting a disconnect signal to the BDU in response to receiving the at least one control signal and/or in response to the determination of the at least one abnormal condition of the battery system. Further preferred, the BDU is configured for disconnecting at least one of the first and second system terminal from at least one battery module in response to receiving the disconnect signal. In other words, the at least one gas sensor, the BMS, and the BDU may together realize an emergency switch-off of the system.

Further preferred, the battery system comprises a plurality of low current connectors constituting a data connection between the at least one battery module and the BMS arranged entirely within the flow channel loop. The low current connectors are preferably arranged entirely within the flow channel loop. In other words, the low current connectors form a low current path, e.g. a data connection, which runs in parallel to the gas flow circulation. Hence, also defects along the entire low current path can be sensed by the at least one gas sensor. Particularly preferred, each battery module comprises a cell supervision circuit, CSC, which is configured to measure the individual cell voltages and the temperatures of the modules and may further be configured to actively or passively balance the cells of a battery module. Further preferred, the low current connectors provide a data connection between the CSCs and the BMS via a daisy chain data connection that must not be a loop.

Preferably, each of the at least one battery module comprises a plurality of aligned battery cells that are electrically connected in series and/or parallel between a first (positive) module terminal and a second (negative) module terminal. Further preferred, a plurality of high current connectors connect a second (negative) system terminal to a second (negative) module terminal of a battery module and a first (positive) system terminal to a first (positive) module terminal of a battery module. Particularly preferred, the plurality of high current connectors comprises at least a first high current connector interconnecting the second system terminal with a second module terminal of at least one battery module and a second high current connector interconnecting a first system terminal with a first module terminal of at least one battery module. The battery system may further comprise a plurality of battery modules that are connected in series between the first system terminal and the second system terminal, and may then further comprise at least one third high current connector that is interconnecting a second module terminal of a first battery module with a first module terminal of a second battery module. The plurality of high current connectors may further comprise a plurality of fourth high current connectors that interconnect the battery cells within battery modules. The first to third high current interconnectors are preferably realized by high current cables and the fourth high current interconnectors are preferably realized by busbars.

Another aspect of the present invention relates to a vehicle, preferably an electric vehicle or a hybrid vehicle, which comprises the battery system of the present invention as described above. According to this embodiment, the BMS of the battery system is preferably data connected to a control unit of the vehicle, e.g. via a CAN bus. Further preferred, the BMS may be then configured to issue a warning to a driver of the vehicle in response to the at least one control signal and/or to request battery service for the vehicle from a service provider.

Another aspect of the present invention relates to a method for detecting an abnormal condition of a battery system, wherein the battery system at least comprises at least one battery module which is interconnected between a first system terminal and a second system terminal by a plurality of high current connectors, a housing with a plurality of exterior walls enclosing the at least one battery module and the plurality of high current connectors and at least one partition wall arranged within the housing. The method of the present invention comprises at least the steps of conveying a gas flow circulation through a flow channel loop formed in the housing by the at least one partition wall and the exterior walls, detecting a concentration of at least one gas species in the gas flow circulation, and transmitting a control signal in response to detecting an excess concentration of the at least one gas species. In the method, the plurality of high current connectors and the at least one battery module constitute a high current path between the first and second system terminal that runs in parallel to the gas flow circulation. Thus, the gas flow circulation follows the high current path.

In a preferred embodiment of the method the gas is conveyed on the flow channel loop by a gas conveyor disposed in the flow channel loop and the concentration of at least one gas species is detected by at least one gas sensor disposed in the flow channel loop. Further preferred, the at least one control signal is transmitted by the at least one gas sensor to a battery management system disposed inside or outside a housing of the battery system. Preferably, the battery system of the invention is utilized for performing the method of the invention.

The method of the present invention may be employed in battery systems employed for different purposes, and preferably in battery systems employed in a vehicle. Independent of the actual application of the battery system, the transmission of the control signal may severely intervene with the normal operation of the battery system. Hence, false positive events that erroneously indicate an abnormal condition of the battery system shall be prevented at any costs. On the other side first signs of imminent failures of components within the battery system should not be ignored and the battery system should be brought to a safe state as early as possible in order to reliably prevent catastrophic events, e.g. a battery fire. The method of the present invention provides such a reliable solution for detecting early signs of an abnormal condition of a battery system as well as for estimating the state of health of safety critical components the battery system.

In the method of the present invention, the state of the battery system is determined in dependence of the concentration of at least one gas species in the battery system. Particularly, a control signal is transmitted if the gas concentration of at least one gas or gas species exceeds a predetermined or learned threshold for that gas or gas concentration. Preferably, a specific control signal out of a plurality of control signals is transmitted in response to detecting a predetermined or learned excess concentration for one or more gases or gas species. Particularly preferred, a specific control signal out of a plurality of control signals is transmitted in response to detecting a predetermined combination of predetermined or learned excess concentrations for a plurality of gases or gas species.

The combination of excess gas concentrations that may occur in the battery system for a specific abnormal operation conditions are indicated in the following table 1 for a plurality of abnormal operation conditions.

**Table 1**

| | **hot spots, plastic smoldering** | **electric arc between live components** | **electrolysis, fluid intrusion, coolant leaks** | **electrolyte leaks** | **cell venting (overpressure)** | **cell Venting (thermal runaway)** | **fire** |
|---|---|---|---|---|---|---|---|
| **carbon dioxide (CO2)** | **X** | | | **X** | **X** | **X** | **X** |
| **carbon monoxide (CO)** | **X** | | | | | **X** | **X** |
| **hydrogen (H₂)** | | | **X** | | | **X** | |
| **oxygen (Os)** | | | **X** | | | | |
| **nitrogen oxides (NOₓ)** | | **X** | | | | | |
| **ozone (Os)** | | **X** | | | | | |
| **water vapor (H₂O)** | **X** | | **X** | | | | |
| **Hydrocarbons** | **X** | | | **X** | **X** | **X** | **X** |
| **smoke/ particles** | **X** | **X** | | | **X** | **X** | **X** |

The method of the present invention may further comprise the step of detecting a combination of excess gas concentrations or gas species concentrations in a forced gas flow circulation provided within a flow channel loop within the battery system's housing and preferably the step of detecting a combination one of the combinations of excess gas concentrations or gas species concentrations as indicated in table 1. This preferred step may be carried out by a gas sensor array disposed in the flow channel loop of the battery system. The method of the present invention may then further comprise the step of transmitting a combination of control signals associated with the detected combination of excess concentrations, preferably to a battery management system, BMS, or another control unit of the battery system. However, the method may also comprise the step of transmitting a single control signal associated with the detected combination of excess concentrations, preferably to the BMS or another control unit of the battery system.

The method of the present invention may further comprise the step of receiving a combination of control signals or a single control signal associated with a detected combination of excess concentrations, and determining the presence of at least one of the abnormal conditions as indicated in table 1 within the battery system. This step is preferably carried out by the BMS of the battery system or any other control unit of the battery system.

The method of the present invention may further comprise the step of, in response to the reception of the control signal(s) and/or the determination of the presence of an abnormal condition on the battery system, controlling, preferably controlling to perform, at least one countermeasure associated with the determined at least one abnormal condition of the battery system.

Particularly preferred, in response to the reception of the control signal(s) and/or the determination of the presence of an abnormal condition on the battery system, it is controlled to disconnect at least one of the first system terminal and the second terminal from the at least one battery module, to switch to an emergency mode of the battery system, to transmit a notification to a user of the battery system, to increase a cooling of the battery system, to reduce a state of power, SOP, of the battery system, and/or to trigger a fire extinguishing system for the battery system.

Therein the step of controlling or controlling to perform a countermeasure may comprise the step of transmitting a countermeasure control signal to an entity that shall actually perform the countermeasure. Preferably, the step of controlling or controlling to perform a countermeasure comprises the step of transmitting a countermeasure control signal via an interface of a battery management system to an exterior of the battery system. Particularly preferred, the step of controlling or controlling to perform a countermeasure comprises the step of transmitting, via an interface of the BMS, a disconnect signal as countermeasure control signal to a battery disconnect unit, BDU, for controlling the BDU to disconnect at least one of the first and second system terminal and the at least one battery module.

Further aspects of the present invention will be apparent from the dependent claims, the attached drawings and/or the following description of the attached drawings.

### Brief Description of the Drawings

Features will become apparent to those of ordinary skill in the art by describing exemplary embodiments in detail with reference to the attached drawings in which:
- Fig. 1: illustrates a perspective view of a battery cell according to an embodiment;
- Fig. 2: illustrates a perspective view of a conventional battery module;
- Fig. 3: illustrates a top view of a battery system according to a first embodiment;
- Fig. 4: illustrates a top view of a battery system according to a second embodiment;
- Fig. 5: illustrates a top view of a battery system according to a third embodiment;
- Fig. 6: illustrates a top view of a battery system according to a fourth embodiment;
- Fig. 7: illustrates a top view of a battery system according to a fifth embodiment;
- Fig. 8: illustrates a schematic front perspective view of a battery system according to a sixth embodiment;
- Fig. 9: illustrates a schematic rear perspective view of the battery system according to the sixth embodiment;
- Fig. 10: illustrates a detailed perspective view of a battery module housing according to the sixth embodiment;
- Fig. 11: illustrates a detailed perspective view of a battery module according to the sixth embodiment;
- Fig. 12: illustrates a cross section of a battery module according to the sixth embodiment; and
- Fig. 13;: illustrates a detailed perspective view of housing parts of the battery system according to the sixth embodiment.

### Detailed Description of the Drawings

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention." Although the embodiments herein are described with various specific embodiments, it will be obvious for a person skilled in the art to practice the invention with modifications. All such modifications are deemed to be within the scope of the claims.

As used herein, the terms "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered around the value. In addition, the use of "may" when describing embodiments of the present invention refers to "one or more embodiments of the present invention." Herein, the terms "upper" and "lower" are defined according to the z-axis. For example, the upper cover is positioned at the upper part of the z-axis, whereas the lower cover is positioned at the lower part thereof.

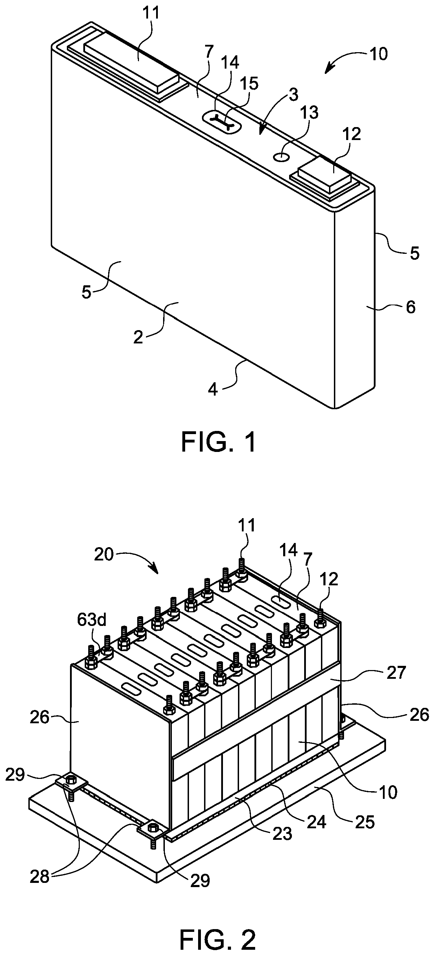

Fig. 1 is a perspective view illustrating a battery cell according to an exemplary embodiment.

As shown in Fig. 1, a battery cell 10 according to an embodiment may include an electrode assembly, and a case 2 for accommodating the electrode assembly, the case 2 containing an electrolyte. The battery cell 10 may also include a cap assembly 3 for sealing an opening of the case 2. The battery cell 10 will be described as a non-limiting example of a lithium ion secondary battery configured to have a prismatic shape.

The case 2 may be configured to have a substantially cuboidal shape, and an opening may be formed at one side thereof. The case 2 may be formed of a metal, such as aluminum. The case 2 may include a bottom surface 4 having a substantially rectangular shape, and may include a pair of first lateral walls 5, that are wide side surfaces 5, and a pair of second lateral walls 6 connected vertically to end portions of the bottom surface 4, respectively, to form a space for accommodating the electrode assembly. The first lateral walls 5 may face each other, and the second lateral walls 6 may be positioned to face each other and may be connected to the first lateral walls 5. A length of an edge at which the bottom surface 4 and one of the first lateral walls 5 are connected to each other may be longer than that of an edge at which the bottom surface 4 and one of the second lateral walls 6 are connected to each other. Preferably, adjacent first 4 and second 5 lateral walls enclose an angle of about 90°.

The cap assembly 3 may include a cap plate 7 for covering the opening of the case 2 by being bonded to the case 2, and may include a positive terminal 11 (first terminal) and a negative terminal 12 (second terminal), which are externally protruded from the cap plate 7 to be electrically connected to the positive electrode and the negative electrode, respectively. The cap plate 7 may be configured to have a shape of a plate that may be extended in one direction, and that may be bonded to the opening of the case 2. The cap plate 3 may include an injection hole 13 and a vent hole 14 that communicate with an interior of the cap assembly 3. The injection hole 13 may be configured to allow injection of the electrolyte solution, and a sealing cap may be mounted thereon or therein. Further, a vent member 14 including a notch 15, which may be opened due to a predetermined pressure, may be mounted to or in the vent hole 14.

Referring to Fig. 2, an exemplary embodiment of a conventional battery module 20 includes a plurality of battery cells 10, e.g. as illustrated in Fig. 1, aligned in one direction and a heat exchange member 23 provided adjacent to a bottom surface of the plurality of battery cells 10. In addition, an elastic member 24 made of rubber or other elastic materials may be interposed between a support plate 25 and the heat exchange member 23. A pair of end plates 26 are provided to face wide surfaces 5 of the battery cells 10 at the outside of the battery cells 10, and a connection plate 27 is configured to connect the pair of end plates 26 to each other thereby fixing the plurality of battery cells 10 together. Fastening portions 28 on both sides of the battery module 20 are fastened to the support plate 25 by bolts 29.

In the battery module 20, each battery cell 10 is a prismatic (or rectangular) cell, the wide flat surfaces 5 of the cells 10 being stacked together to form the battery module 20. The positive and negative electrode terminals 11 and 12 of neighboring battery cells 10 are electrically connected through a bus bar 63d, and the bus bar 63d may be fixed by a nut or the like. Hence, the battery module 20 may be used as power source unit by electrically connecting the plurality of battery cells 10 as one bundle.

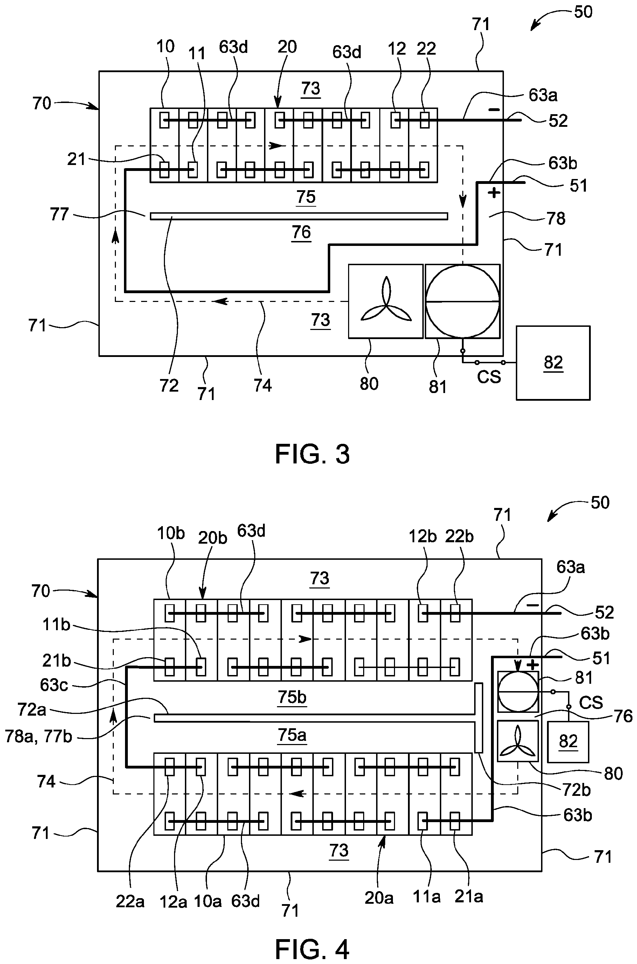

Fig. 3 is a top view illustrating a battery system 50 according to a first embodiment.

The battery system 50 illustrated in Figure 3 is a battery system 50 as utilized in an electric vehicle and has an overall dimension of about 0.6 m * 0.4 m * 0.13 m (width/depth/height) and is thus a battery system 50 with a single level. The battery system 50 comprises a housing 70 with a support plate (not shown), four lateral exterior walls 71 and a single linearly extended partition wall 72 arranged at a center of the housing 70. The housing 70 may be closed by a top cover (not shown) for providing an essentially gastight housing 70 for battery system 50.

The partition wall 72 divides the housing 70 in a cell compartment 75 and an additional compartment 76, wherein the cell compartment 75 is connected to the additional compartment 76 via a gas inlet 77 and a gas outlet 78. The partition wall 72 is essentially gastight and extends along the whole height of the housing 70. Thus, a flow channel loop 73 is formed in the interior of the housing 70 and extends from the additional compartment 76, via the gas inlet 77 into the cell compartment 75 and from there via the gas outlet 78 again into the additional compartment 76. A gas conveyor 80 in form of a fan 80 and a gas sensor array 81, comprising a plurality of gas sensors, are arranged in the flow channel loop 73, particularly in the additional compartment 76.

The fan 80 is configured for providing a gas flow circulation 74 along the flow channel loop 73 as indicated by the dashed line in Fig. 1. The gas flow circulation 74 begins at the fan 80 and runs through the additional compartment 76, from there via the gas inlet 77 into the cell compartment 75 and from there via the gas outlet 78 to the gas sensor array 81 and fan 80.

A battery module 20 is arranged in the cell compartment 75. The battery module 20 comprises ten aligned battery cells 10 that are stacked in a stacking direction with their wide side surfaces facing each other. The stacking direction of the battery module 20 is also the longitudinal direction of the battery module 20 along which the battery module 20 has its largest extension. The battery module 20 is positioned in the cell compartment 75 with its longitudinal direction being essentially parallel to the partition wall 72.

The battery cells 10 of the battery module 20 are connected to each other via busbars 63d (fourth high current connectors 63d) in a 2p5s configuration. Therefore, each busbar 63d connects two first cell terminals 11 and two second cell terminals 12, i.e. a total of four cell terminals 11, 12 to each other. A second module terminal 22 of the battery module 20 is connected to a second (negative) system terminal 52 of the battery system 50 via a first high current connector 63a, particularly via a first high current cable 63a, and a first module terminal 21 of the battery module 20 is connected to a first (positive) system terminal 51 of the battery system 50 via a second high current connector 63b, particularly via a second high current cable 63b.

A high current path is formed by the first high current connector 63a, the second high current connector 63b, and the fourth high current busbars 63d. This current path extends from the first system terminal 51 via the gas outlet 78 into and through the additional compartment 76, from there via the gas inlet 77 into the cell compartment 75, and from there via the battery module 20 to the second system terminal 52. Hence the current path is disposed entirely within the flow channel loop 73 and follows the gas flow circulation 74. In other words, the gas flow circulation 74 flows around all components of the high current path and over all battery cells 10 of the battery module 20 and hence gas flow circulation will take up any gas or particle emission of any of the components of the current path or the battery cells 10.

The gas sensor array 81 is carefully positioned in the additional compartment 76 such that all of the gas flow 74 circulating in the flow channel loop 73 must pass through the gas sensor array 81. The gas sensor array 81 thus detects the concentration of at least one gas or gas species in the gas flow circulation 74. If the gas sensor array 81 detects that the concentration of at least one gas or gas species in the gas flow circulation 74 exceeds a predetermined or learned threshold, i.e. detects an excess concentration of at least one gas or gas species in the gas flow circulation 74, the gas sensor array 81 transmits a control signal, CS, to a battery management system, BMS, 82 located outside the housing 70 of the battery system 50. The BMS 82 may then determine the presence of an abnormal condition in the battery system 50 and perform or control to perform at least one countermeasure associated with the determined abnormal condition, such as e.g. transmit a warning signal to the vehicle's driver.

Fig. 4 is a top view illustrating a battery system 50 according to a second embodiment. Like components of the battery system of Fig. 4 are denoted with like reference signs as in Fig. 3 and a description of the battery system 50 of Fig. 4 is omitted as far as it is equal to the battery system 50 of Fig. 3.

The battery system 50 of Fig. 4 differs from that of Fig. 3 as it comprises two partition walls 72a, 72b that form a T-shaped partition wall 72. A first section 72a of the T-shaped partition wall 72 is positioned as the partition wall 72 of Fig. 3 and a second section 72b of the T-shaped partition wall 72 is positioned at a right angle to and in contact with the first section 72a. The second section 72b is shorter than the first section 72a.

Two cell compartments 75a, 75b are formed on both sides of the first section 72a between exterior walls 71 and the partition wall 72 and two battery modules 20a, 20b are positioned in the cell compartments 75a, 75b. Therein, the longitudinal direction of the battery modules 20a, 20b is in parallel to the first section 72a. An additional compartment 76 is formed between the second section 72b and an exterior wall 71 and the fan 80 and the gas sensor array 81 are positioned in the additional compartment 76.

Each of the battery modules 20a, 20b comprises ten aligned battery cells 10a, 10b that are stacked in the longitudinal direction with their wide side surfaces facing each other. The cells 10a, 10b are connected to each other in a 2p5s configuration by four busbars 63d, respectively. A first system terminal 51 is connected to a first module terminal 21a of the first battery module 20a via a second high current connector 63b. A second module terminal 22a of the first module 20a is connected to a first module terminal 21b of the second module 20b via a third high current connector 63c, and a second module terminal 22b of the second module 22b is connected to a second system terminal 52 via a first high current connector 63a.

The first, second, third and fourth high current connectors 63a, 63b, 63c, 63d form a current path that extends from the second system terminal 52 to the first system terminal 51 through the entirety of a flow channel loop 73 formed by the additional compartment 76, the first cell compartment 75a, and the second cell compartment 75b. Therein, the first cell compartment 75a is connected to the second cell compartment via a first gas outlet 78a that is also the second gas inlet 77b of the second cell compartment 75b. A gas flow circulation 74 provided by the fan 80 within the flow channel loop 73 follows the current path and flows around all battery cells 10 and all high current connectors 63 of the battery system 50.

The gas flow circulation 74 must pass the gas sensor array 81 that thus detects any excess gas or particle concentration therein. In response to detecting an excess gas concentration, the gas sensor array 81 transmits a control signal CS to a battery management system 82 which is positioned outside the housing 70. The battery management system 82 may then determine the presence of an abnormal condition in the battery system 50 and perform or control to perform at least one countermeasure associated with the determined abnormal condition. Particularly, the BMS 82 may transmit a warning signal to the vehicle's driver or shut off the system 50.

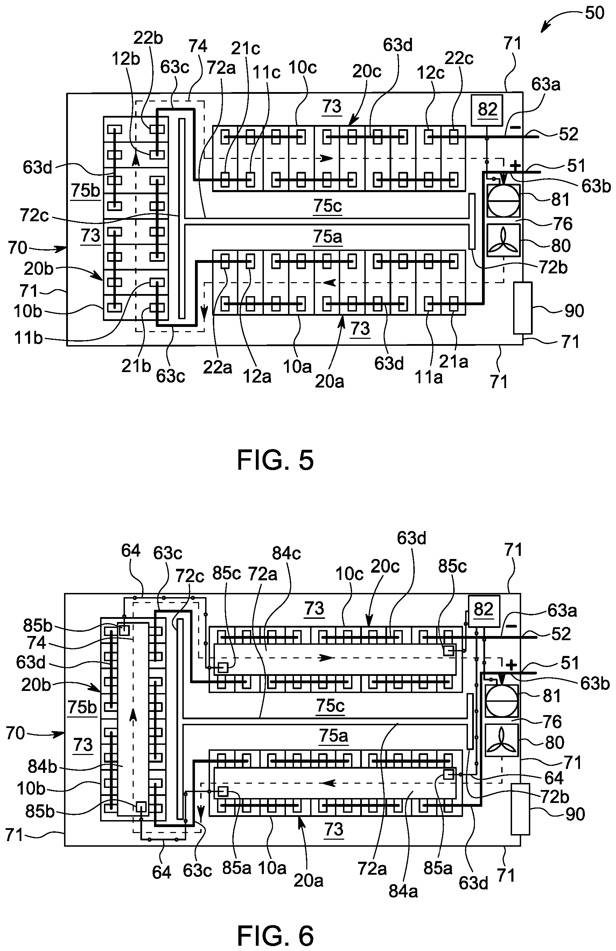

Fig. 5 is a top view illustrating a battery system 50 according to a third embodiment. Like components of the battery system of Fig. 5 are denoted with like reference signs as in Figs. 3 and 4 and a description of the battery system 50 of Fig. 5 is omitted as far as it is equal to the battery systems 50 of Figs. 3 and 4.

The battery system 50 of Fig. 5 differs from Figs. 3 and 4 as housing 70 of the battery system 50 comprises three partition walls 72a, 72b, 72c that form a double T-shaped partition wall 72. A first section 72a of the double T-shaped partition wall 72 is positioned as the first section 72a of Fig. 4 and a second section 72b of the T-shaped partition wall 72 is positioned as the second section 72b of Fig. 4. A third section 72c of the partition wall 72 is positioned at a right angle to and in contact with the first section 72a and opposite and parallel to the second section 72b. The third section 72c is shorter than the first section 72a and longer than the second section 72b. Housing 70 further differs in that it comprises a pressure equalization filter 90 arranged within an exterior wall 71 that is configured to allow a limited gas communication between an interior and an exterior of the housing 70 in order to prevent over- or underpressure within housing 70. Filter 90 may block dust from entering the housing 70.

Two cell compartments 75a, 75c are formed on both sides of the first section 72a between exterior walls 71 and the partition wall 72. Two battery modules 20a, 20c are positioned in the cell compartments 75a, 75c. Therein, the longitudinal direction of the battery modules 20a, 20c is in parallel to the first section 72a. Another cell compartment 75b is formed between the third section 72c and an exterior wall 71 and a battery module 20b is positioned in the cell compartment 75b. An additional compartment 76 is formed between the second section 72b and an exterior wall 71 and the fan 80 and the gas sensor array 81 are positioned in the additional compartment 76.

The battery modules 20a, 20c each comprise ten aligned battery cells 10a, 10c that are stacked in the longitudinal direction with their wide side surfaces facing each other. The cells 10a, 10c are connected to each other in a 2p5s configuration by four busbars 63d, respectively. The battery module 20b comprises eight aligned battery cells 10b that are stacked in the longitudinal direction with their wide side surfaces facing each other. The cells 10b are connected to each other in a 2p4s configuration by three busbars 63d. A first system terminal 51 is connected to a first module terminal 21a of the first battery module 20a via a second high current connector 63b. A second module terminal 22a of the first module 20a is connected to a first module terminal 21b of the second module 20b via a third high current connector 63c. A second module terminal 22b of the second module 20b is connected to a first module terminal 21c of the third module 20c via another third high current connector 63c and a second module terminal 22c of the third module 20c is connected to a second system terminal 52 via a first high current connector 63a.

The first, second, third and fourth high current connectors 63a, 63b, 63c, 63d form a current path that extends from the second system terminal 52 to the first system terminal 51 through the entirety of a flow channel loop 73 formed by the cell compartments 75a, 75b, 75c, and the additional compartment 76. A gas flow circulation 74 provided by the fan 80 within the flow channel loop 73 follows this current path and flows around all battery cells 10 and all high current connectors 63 of the battery system 50.

The gas flow circulation 74 must pass the gas sensor array 81 that thus detects any excess gas or particle concentration therein. In response to detecting an excess gas concentration, the gas sensor array 81 transmits a control signal CS to a battery management system 82 which is positioned inside the housing 70. The BMS 82 may then determine the presence of an abnormal condition in the battery system 50 and perform or control to perform at least one countermeasure associated with the determined abnormal condition. Particularly, the BMS 82 may transmit a warning signal to the vehicle's driver or shut off the system 50.

Fig. 6 is a top view illustrating a battery system 50 according to a fourth embodiment. Like components of the battery system of Fig. 6 are denoted with like reference signs as in Fig. 5 and a description of the battery system 50 of Fig. 6 is omitted as far as it is equal to the battery systems 50 of Fig. 5.

The battery system of Fig. 6 differs from the battery system of Fig. 5 in that each of the battery modules 20a, 20b, 20c comprises a cell supervision circuit, CSC, 84a, 84b, 84c, respectively. The CSCs 84a, 84b, 84c are arranged on top of the battery modules 20a, 20b, 20c and are connected to at least some of the battery cells 10a, 10b, 10c of the respective battery module 20a, 20b, 20c in order to measure cell voltages of the connected battery cells 10a, 10b, 10c. The CSCs 84a, 84b, 84c may further be configured to measure temperatures of the individual battery modules 20a, 20b, 20c and/or to provide active or passive cell balancing between the battery cells 10a, 10b, 10c of the respective battery modules 20a, 20b, 20c.

The CSCs 84a, 84b, 84c are connected to the battery management system, BMS, 82, via a plurality of low current connectors 64. Each of the CSCs 84a, 84b, 84c comprises two contact pads 85a, 85b, 85c for providing a connection to the low current connectors 64. A connection between the contact pads 85 of adjacent battery modules 20 or between a battery module 20 and the BMS 82 is thus established via low current connectors 64 connected to at least one of the contact pads 85. The plurality of low current connectors 64 form a data connection between the BMS 82 and the CSCs 84a, 84b, 84c, of the modules 20a, 20b, 20c. The data connection may be a looped or single ended data connection.

As illustrated in Figure 6, the low current connectors 64 run through the entirety of a flow channel loop 73 formed by the cell compartments 75a, 75b, 75c, and the additional compartment 76. A gas flow circulation 74 provided by the fan 80 within the flow channel loop 73 thus follows the data connection and flows around all battery cells 10, all high current connectors 63 and all low current connectors 64 of the battery system 50. The gas flow circulation 74 must pass the gas sensor array 81 that thus detects any excess gas or particle concentration therein.

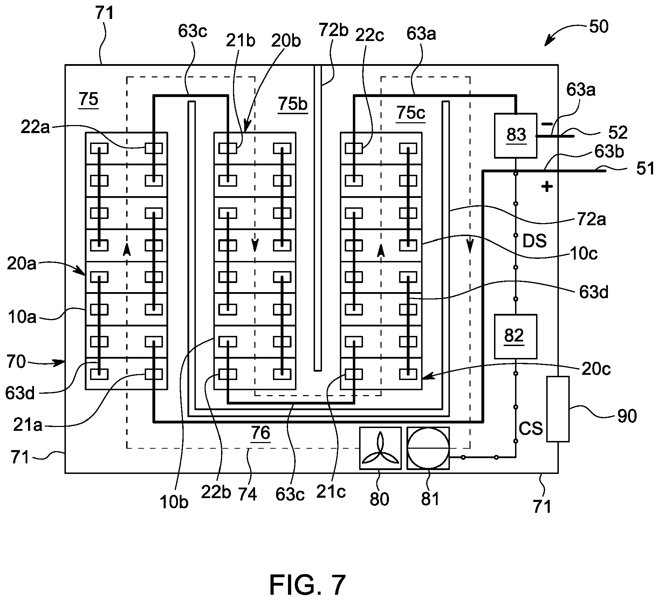

Fig. 7 is a top view illustrating a battery system 50 according to a fifth embodiment. Like components of the battery system of Fig. 5 are denoted with like reference signs as in Figs. 3 to 6 and a description of the battery system 50 of Fig. 7 is omitted as far as it is equal to the battery systems 50 of Figs. 3 to 6.

The battery system 50 of Fig. 7 differs from Figs. 3 to 6 as the housing 70 of the battery system 50 comprises a first U-shaped partition wall 72a arranged in the center of the housing 70 without contact to any exterior wall 71 and a second partition wall 72b that extends perpendicularly from a exterior wall 71 and into the U-shaped partition wall 72a.

The lower horizontal section of the U-shaped partition wall 72a extends in parallel to an exterior wall 71 and an additional compartment 76 is formed between the lower horizontal section of the U-shaped partition wall 72a and the exterior wall 71. Further, three cell compartments 75a, 75b, 75c are formed between the two vertical sections of the U-shaped partition wall 72a and the second partition wall 72b. Respective battery modules 20a, 20b, 20c are positioned in the cell compartments 75a, 75b, 75c, with their longitudinal directions being parallel to the second partition wall 72b.

The battery modules 20a, 20b, 20c each comprise eight aligned battery cells 10a, 10b, 10c that are stacked in the longitudinal direction with their wide side surfaces facing each other. The cells 10a, 10b, 10c are connected to each other in a 2p4s configuration by three busbars 63d, respectively.

A first system terminal 51 is connected to a first module terminal 21a of the first battery module 20a via a second high current connector 63b. A second module terminal 22a of the first module 20a is connected to a first module terminal 21b of the second module 20b via a third high current connector 63c. A second module terminal 22b of the second module 20b is connected to a first module terminal 21c of the third module 20c via another third high current connector 63c and a second module terminal 22c of the third module 20c is connected to a second system terminal 52 via a first high current connector 63a.

The first, second, third and fourth high current connectors 63a, 63b, 63c, 63d form a current path that extends from the second system terminal 52 to the first system terminal 51 through the entirety of a flow channel loop 73 formed by the cell compartments 75a, 75b, 75c, and the additional compartment 76. A gas flow circulation 74 provided by the fan 80 within the flow channel loop 73 follows this current path and flows around all battery cells 10 and all high current connectors 63 of the battery system 50.

The gas flow circulation 74 must pass the gas sensor array 81 that thus detects any excess gas or particle concentration therein. In response to detecting an excess gas concentration, the gas sensor array 81 transmits a control signal, CS, to a battery management system 82, which is positioned inside the housing 70. The BMS 82 may then determine the presence of an abnormal condition in the battery system 50.

In response to determining an abnormal condition in the battery system 50, the BMS 82 transmits a disconnect signal, DS, to a battery disconnect unit, BDU, 83 that is interconnected between the second system terminal 52 and the second module terminal 22c of the battery module 20c. In response to receiving the disconnect signal, DS, the BDU 83 disconnects the electrical connection between the module 20c and the second system terminal 52. Hence, an emergency shut down of the battery system 50 is performed.

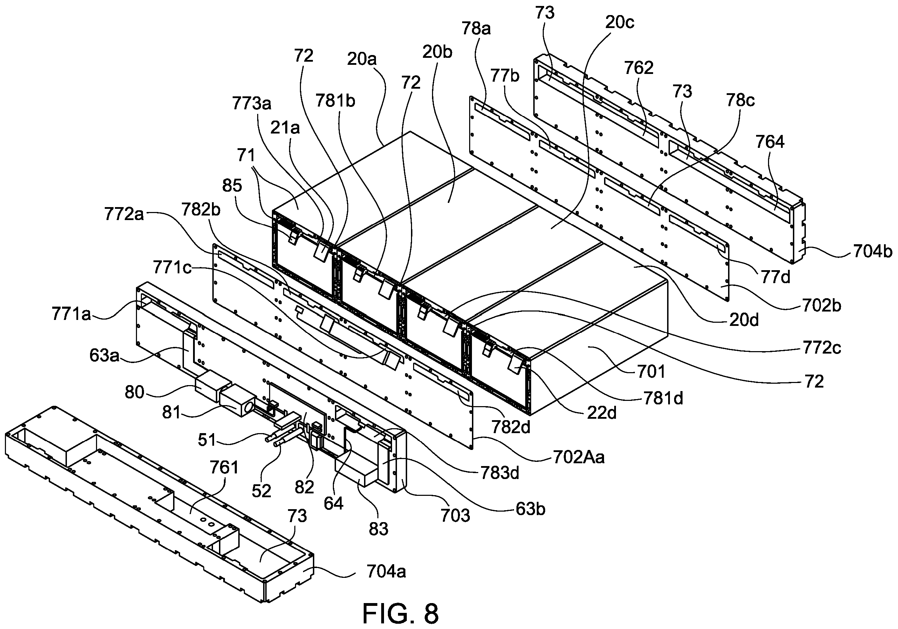

Fig. 8 is a schematic perspective front view illustrating a battery system 50 according to a sixth embodiment. Like components are denoted with like reference signs as in Figs. 3 to 7. In the battery system 50 of Fig. 8 the battery system housing 70 comprises of a plurality of components and the flow channel loop 73 is formed by the combination of these components.

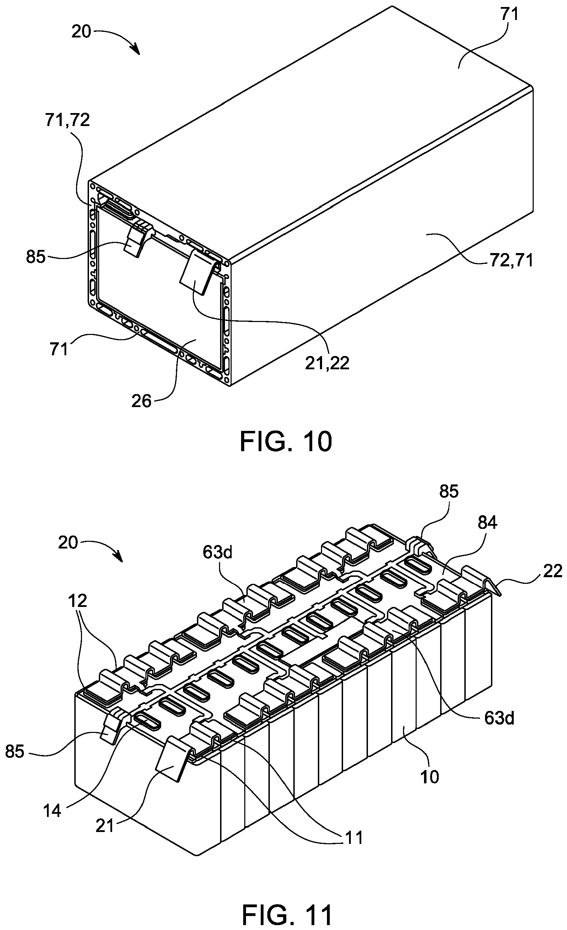

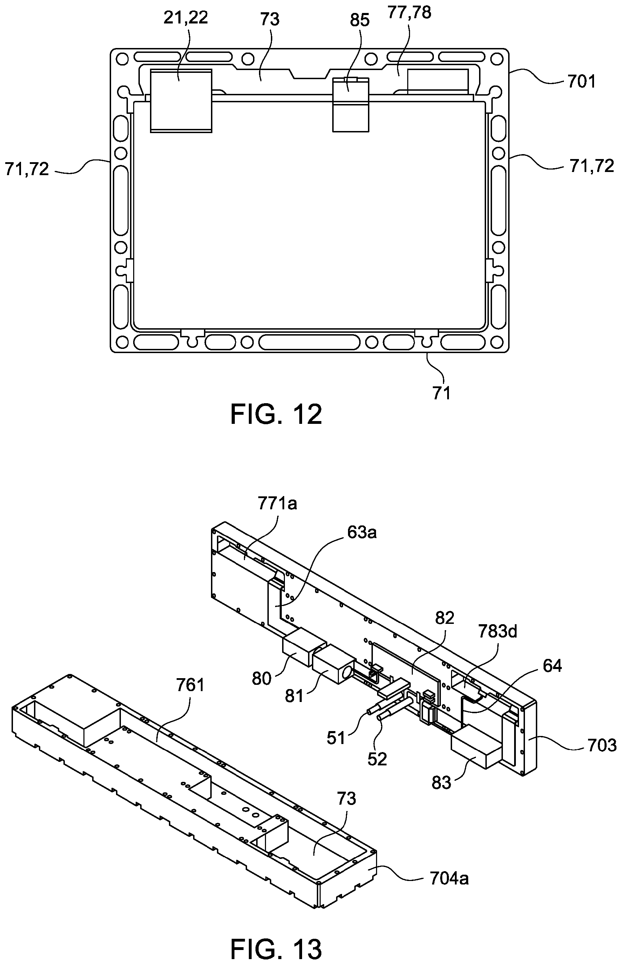

The battery system 50 comprises four battery modules 20a-d that are enclosed by a module housing part 701. The module housing part 701 is formed by a plurality of extruded aluminum profiles, each enclosing a single battery module as shown in more detail in Figs. 10 and 12. Each extruded aluminum profile covers the top, bottom, and side surfaces of the respective battery modules 20a-d. The walls of the extruded aluminum profiles form either exterior walls 71 or partition walls 72 depending on the position of the extruded aluminum profile in the module housing part 701. The walls of the extruded aluminum profiles comprises hollows in order to provide a lightweight battery system 50. The extruded aluminum profiles are connected to each others via suitable connecting means (not shown) or a weld connection, such that the battery modules 20a-d are arranged next to each other with their front and end surfaces, each covered by an end plate 26, being parallel aligned to each other, respectively.

A battery module 20 as depicted in Fig. 11 is disposed in each of the extrusion aluminum profiles as depicted in Figs. 10 and 12. As illustrated in Fig. 12 a gas flow channel 73 is left open between an upper side of the battery module 20 (i.e. all the cap assemblies 3 of the battery cells 10) such that a gas flow circulation 74 can pass over each of the battery cells 10.

The battery system housing 70 further comprises pressure plates 702 that are disposed adjacent to the aligned front and end surfaces, respectively. On a front side of the battery system 50, a first pressure plate 702a is arranged adjacent to the aligned front surfaces of the battery modules 20a-d. A ground cover 703 is arranged adjacent to the first pressure plate 702a and a first side cover 704a is arranged adjacent to the ground cover 703 such that the ground cover 703 is arranged in between the first pressure plate 702a and the first side cover 704a. On a rear side of the battery system 50, a second pressure plate 702b is arranged adjacent to the aligned end surfaces of the battery modules 20a-d and a second side cover 704b is arranged adjacent to the second pressure plate 702b such that the second pressure plate 702b is disposed between the battery modules 20a-d and the second side cover 704b.

A gas conveyor 80, a gas sensor 81, a BMS 82, and a BDU 83 are disposed on a front side of the ground cover 703 and are configured to fit in a first additional compartment 761 formed as a recess on an inner (rear) surface of the first side cover 704a as illustrated in more detail in Fig. 13. The first additional compartment 761 constitutes a part of the flow channel loop 73. A first system terminal 51 and a second system terminal 52 emerge from the ground cover 703 and penetrate outwards through respective openings in the first side cover 704a.

The first system terminal 51 is connected via a first high current connector 63a to a first module terminal 21a of a first battery module 20a. Therefore the first high current connector 63a passes through a first gas inlet 771a in the ground cover 703 and through a second gas inlet 772a in the first pressure plate 702a. As illustrated in Fig. 11, the first module terminal 21a is connected to first cell terminals 11 of two outermost cells 10 and the second cell terminals 12 of these two outermost cells 10 are connected via a busbar 63d to two adjacent battery cells 10. These adjacent two battery cells 10 are again connected to another pair of adjacent battery cells 10 via a further busbar 63d and so forth until another pair of outermost battery cells 10 is reached. The second cell terminals 12 of this other pair or outermost battery cells 10 are connected to second module terminal 22. In the battery module 20 of Fig. 11 twelve battery cells 10 are so connected to each other in a 2p6s configuration.

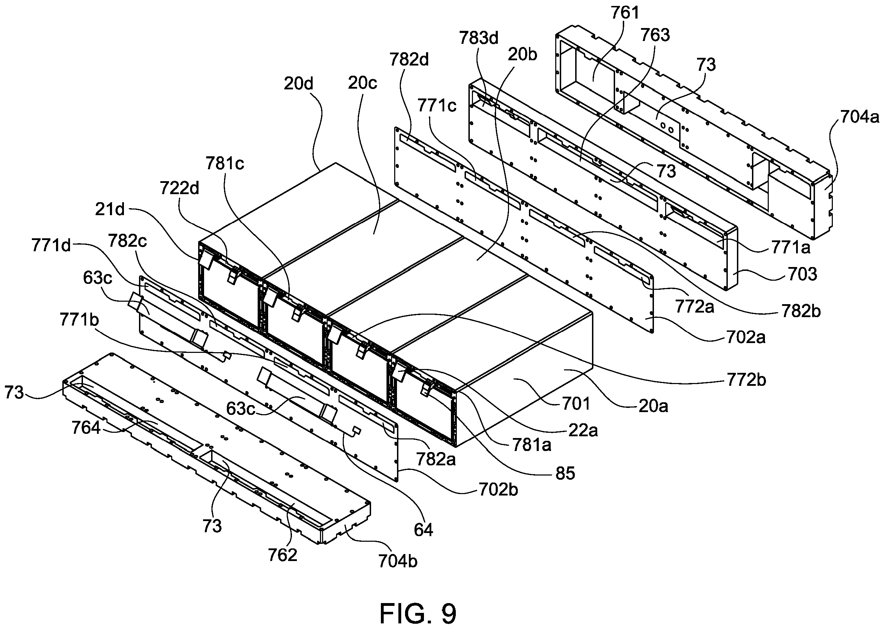

As illustrated in Fig. 9, the second module terminal 22a of the first battery module 20a is connected via a third high current connector 63c, which is attached to the second pressure plate 702b, to the first module terminal 21b of an adjacent second battery module 20b. The second battery module 20b also has the configuration as shown in Fig. 11. A second module terminal of the second battery module 20b is connected to the first module terminal 21c of an adjacent third battery module 20c via a third high current connector 63c, which is attached to the first pressure plate 702a. The third battery module 20c also has the configuration as shown in Fig. 11. A second module terminal of the third battery module 20c is connected to the first module terminal 21d of an adjacent fourth battery module 20d via a third high current connector 63c, which is attached to the second pressure plate 702b. The fourth battery module 20d also has the configuration as shown in Fig. 11. A second module terminal 22d of the fourth battery module 20d is connected to the second system terminal 52 via a second high current connector 63b that is connected to the ground cover 703. The second high current connector 63b passes through a second gas outlet 782d in the first pressure plate 702a and a third gas outlet 783d in the ground cover 703. A closed high current path between the first system terminal 51 and the second system terminal 52 is thus formed by the combination of the first to third high current connectors 63a-c and the busbars 63d.

This high current path between the first and second system terminals 51, 52 is entirely within a flow channel loop 73 formed within the housing of the battery system 50 according to the sixth embodiment. Therein, a gas flow circulation 74 is actuated by gas conveyor 80 within the first additional compartment 761 of the first side cover 704a. The gas flow circulation 74 then passes through the first gas inlet 771a and the second gas inlet 772a described above into a third gas inlet 773a formed by the front cross section of the gap between the first battery module 20a and the extruded aluminum profile enclosing it (see also Fig. 11). The gas flow circulation 74 then passes over all battery cells 10 of the first battery module 20a and leaves the aluminum extrusion profile via the first gas outlet 781a formed by the rear cross section of the gap between the first battery module 20a and the extruded aluminum profile enclosing it as illustrated in Fig. 9.

The gas flow circulation 74 leaving the first battery module via first gas outlet 781a then passes through the second gas outlet 782a in the second pressure plate 702b into a second additional compartment 762 formed as a recess in a inner (front) side of the second side cover 704b. This second additional compartment 762 is in fluid connection with the second gas outlet 782a and with an adjacent first gas inlet 771b in the second pressure plate 702b and fluidly connects the second gas outlet 782a and the first gas inlet 771b as part of the flow channel loop 73. The gas flow circulation 74 passes through the first gas inlet 771b into a second gas inlet 772b, wherein the second gas inlet is formed by the rear gap between the second battery module 20b and the extruded aluminum profile enclosing it.

The gas flow circulation 74 then passes through the whole second battery module 20b and flows over all battery cells 10 and busbars 63d of second battery module 20b. The gas flow circulation 74 leaves the second battery module 20b via a first gas outlet 781b formed by the front gap between the second battery module 20b and the enclosing aluminum profile and through a second gas outlet 782b formed in the first pressure plate 702a. A third additional compartment 763 is formed as a recess in an inner (rear) side of ground cover 703 and fluidly connects the first gas outlet 781b associated with the second battery module 20b and the first gas inlet 771c associated with the third battery module 20c. The gas flow circulation 74 passes through the first gas inlet 771c into a second gas inlet 772c, which is formed by the front gap between third battery module 20c and the extruded aluminum profile enclosing it.

The gas flow circulation 74 then passes through the whole third battery module 20c and flows over all battery cells 10 and busbars 63d of third battery module 20c. The gas flow circulation 74 leaves the third battery module 20c via first gas outlet 781c formed by the rear gap between the third battery module 20c and the enclosing aluminum profile and through a second gas outlet 782c formed in the second pressure plate 702b. The gas flow circulation 74 then passes into a fourth additional compartment 764 formed as a recess in an inner (front) side of the second side cover 704b. This fourth additional compartment 764 is in fluid connection with the second gas outlet 782c and with a first gas inlet 771d in the second pressure plate 702b and fluidly connects the second gas outlet 782c and the first gas inlet 771d as part of the flow channel loop 73. The gas flow circulation 74 passes through the first gas inlet 771d into a second gas inlet 772d, which is formed by the rear gap between the fourth battery module 20d and the extruded aluminum profile enclosing it.

The gas flow circulation 74 then passes through the whole fourth battery module 20d and flows over all battery cells 10 and busbars 63d of fourth battery module 20d. The gas flow circulation 74 leaves the fourth battery module 20d via a first gas outlet 781d formed by the front gap between the fourth battery module 20d and the enclosing aluminum profile, through a second gas outlet 782d formed in the first pressure plate 702a, and through a third gas outlet 783d formed in the ground cover 703. The gas flow circulation 74 then flows again into and through the first additional compartment 761 as part of the flow channel 73 and finally passes the gas sensor 81 for gas concentration analysis. The gas flow circulation 74 is then again actuated by gas conveyor 80 for another loop through flow channel loop 73.

Hence, in the battery system 50 according to the sixth embodiment, the gas flow circulation 74 follows the high current path formed by the first to third high current connectors 63a-c and the busbars 64d through the multipart housing 70 of the battery system 50. Thus, any gas emitted by any part of the battery system 50 that is associated with the high current path is picked up the gas flow circulation 74 and can be detected by gas sensor 81.

### Reference signs

- 2: case
- 3: cap assembly
- 4: bottom surface
- 5: first lateral walls (wide side surfaces)
- 6: second lateral walls (narrow side surface)
- 7: cap plate

- 10: battery cell
- 11: first cell terminal (positive)
- 12: second cell terminal (negative)
- 13: injection hole
- 14: vent hole
- 15: notch

- 20a-d: first to fourth battery module
- 21: first module terminal (positive)
- 22: second module terminal (negative)
- 23: heat exchange member
- 24: elastic member
- 25: support plate
- 26: end plates
- 27: connection plate
- 28: fastening portion
- 29: bolt
- 50: battery system
- 51: first system terminal (positive)
- 52: second system terminal (negative)

- 63: high current connectors
- 63a: first high current connector
- 63b: second high current connector
- 63c: third high current connector
- 63d: busbars
- 64: low current connector

- 70: housing
- 701: housing part
- 702: pressure plate
- 703: ground cover
- 704: side cover
- 71: exterior wall
- 72: partition wall
- 73: flow channel loop
- 74: gas flow circulation
- 75: cell compartment
- 76: additional compartment
- 77: gas inlet
- 78: gas outlet
- 80: gas conveyor
- 81: gas sensor
- 82: battery management system (BMS)
- 83: battery disconnect unit (BDU)
- 84: cell supervision circuit (CSC)
- 85: contact pad
- CS: control signal
- DS: disconnect signal

- 90: pressure equalization filter

## Claims

1. A battery system (50), comprising
at least one battery module (20) interconnected between a first system terminal (51) and a second system terminal (52) by a plurality of high current connectors (63); and
a housing (70) with a plurality of exterior walls (71) enclosing the at least one battery module (20) and the plurality of high current connectors (63) and with at least one partition wall (72) arranged within the housing (70);
wherein a flow channel loop (73) is formed within the housing (70) by the at least one partition wall (72) and the exterior walls (71),
wherein a gas conveyor (80) configured for providing a gas flow circulation (74) through the flow channel loop (73) and at least one gas sensor (81) configured for detecting an excess concentration of at least one gas species in the gas flow circulation (74) are arranged in the flow channel loop (73), and
wherein the gas flow circulation (74) is formed to follow a high current path constituted by the plurality of high current connectors (63) and the at least one battery module (20) between the first and second system terminals (51, 52) by the at least one partition wall (72).

2. The battery system (50) of claim 1, wherein the at least one battery module (20) and the plurality of high current connectors (63) are arranged entirely within the flow channel loop (73).

3. The battery system (50) of claim 1 or 2, wherein the gas flow circulation (74) circulates around the entire at least one battery module (20), the entire plurality of high current connectors (63) and the at least one gas sensor (81).

4. The battery system (50) of any one of the preceding claims, wherein the flow channel loop (73) comprises at least one cell compartment (75) configured for receiving at least one battery module (20) and at least one additional compartment (76) configured for receiving at least one of the gas conveyor (80) and the at least one gas sensor (81).

5. The battery system (50) of claim 4, wherein at least one battery module (20) is disposed within each cell compartment (75) with one of a first and second module terminal (21) proximate to a gas inlet (77) of the cell compartment (75) and another one of the first and second module terminal (22) proximate to a gas outlet (78) of the cell compartment (75).

6. The battery system (50) of claim 4 or 5, wherein one of the at least one cell compartments (75a) is fluidly connected to a gas outlet (78b) of an adjacent cell compartment (75b) or the additional compartment (76) via a gas inlet (77a) and to a gas inlet (77b) of an adjacent cell compartment (75b) or the additional compartment (76) via a gas outlet (78a).

7. The battery system (50) of any one of the preceding claims, comprising a gas sensor array (81) with a plurality of gas sensors, wherein each gas sensor is configured for detecting a concentration of at least one gas species in the gas flow circulation.

8. The battery system (50) of any one of the preceding claims, further comprising a battery management system, BMS, (82) connected to the at least one gas sensor (81), wherein the at least one gas sensor (81) is configured for transmitting a control signal, CS, to the BMS (82) in response to detecting the excess concentration of at least one gas species in the gas flow circulation (74).

9. The battery system (50) of claim 8, further comprising a battery disconnect unit, BDU, (83) interconnected between at least one of the first and second system terminal (51, 52) and the at least one battery module (20), wherein the BMS (82) is configured for transmitting a disconnect signal, DS, to the BDU (83) in response to receiving the control signal, CS, and wherein the BDU (83) is configured for disconnecting at least one of the first and second system terminal (51, 52) and the at least one battery module (20) in response to the disconnect signal, DS.

10. The battery system (50) of claim 8, further comprising a plurality of low current connectors (64) constituting a data connection between the at least one battery module (20) and the BMS (82) and being arranged entirely within the flow channel loop (73).

11. The battery system (50) of any one of the preceding claims, wherein the plurality of high current connectors (63) comprises at least a first HV connector (63a) interconnecting a second system terminal (52) with a second module terminal (22) of the at least one battery module (20) and a second HV connector (63b) interconnecting a first system terminal (51) with a first module terminal (21) of the at least one battery module (20).

12. The battery system (50) of claim 11, comprising a plurality of battery modules (20a, 20b, 20c) connected in series between the first system terminal (51) and the second system terminal (52), and at least one third HV connector (63c) interconnecting a second module terminal (22a) of a first battery module (20a) with a first module terminal (21b) of a second battery module (20b).

13. An electric vehicle comprising the battery system (50) of any one of the claims 1 to 12.

14. Method for detecting an abnormal condition of a battery system (50) comprising at least one battery module (20) interconnected between a first system terminal (51) and a second system terminal (52) by a plurality of high current connectors (63), a housing (70) with a plurality of exterior walls (71) enclosing the at least one battery module (20) and the plurality of high current connectors (63) and at least one partition wall (72) arranged within the housing (70), the method comprising the steps:
conveying a gas flow circulation (74) through a flow channel loop (73) formed in the housing (70) by the exterior walls (71) and the at least one partition wall (72),
detecting a concentration of at least one gas species in the gas flow circulation (74),
transmitting at least one control signal, CS, in response to detecting an excess concentration of at least one gas species,
wherein the gas flow circulation (74) is formed to follow a high current path constituted by the plurality of high current connectors (63) and the at least one battery module (20) between the first and second system terminals (51, 52) by the at least one partition wall (72).

15. Method of claim 14, further comprises the steps:
determining the presence of at least one abnormal condition in the battery system (50),
controlling at least one countermeasure to the present at least one abnormal condition.

## Patentansprüche

1. Batteriesystem (50), umfassend
mindestens ein Batteriemodul (20), das zwischen einem ersten Systemanschluss (51) und einem zweiten Systemanschluss (52) durch eine Vielzahl von Hochstromverbindern (63) verbunden ist; und
ein Gehäuse (70) mit einer Vielzahl von Außenwänden (71), die das mindestens eine Batteriemodul (20) und die Vielzahl von Hochstromverbindern (63) umschließen, und mit mindestens einer Trennwand (72), die innerhalb des Gehäuses (70) angeordnet ist;
wobei innerhalb des Gehäuses (70) durch die mindestens eine Trennwand (72) und die Außenwände (71) eine Strömungskanalschleife (73) ausgebildet ist,
wobei ein Gasförderer (80), der konfiguriert ist, um einen Gasstromkreislauf (74) durch die Strömungskanalschleife (73) bereitzustellen, und mindestens ein Gassensor (81), der konfiguriert ist, um eine überschüssige Konzentration von mindestens einer Gasspezies im Gasstromkreislauf (74) zu erfassen, in der Strömungskanalschleife (73) angeordnet sind, und
wobei der Gasstromkreislauf (74) ausgebildet ist, um einem Hochstrompfad zu folgen, der durch die Vielzahl von Hochstromverbindern (63) und das mindestens eine Batteriemodul (20) zwischen dem ersten und zweiten Systemanschluss (51, 52) durch die mindestens eine Trennwand (72) gebildet wird.

2. Batteriesystem (50) nach Anspruch 1, wobei das mindestens eine Batteriemodul (20) und die Vielzahl von Hochstromverbindern (63) vollständig innerhalb der Strömungskanalschleife (73) angeordnet sind.

3. Batteriesystem (50) nach Anspruch 1 oder 2, wobei der Gasstromkreislauf (74) um das gesamte mindestens eine Batteriemodul (20), die gesamte Vielzahl von Hochstromverbindern (63) und den mindestens einen Gassensor (81) zirkuliert.

4. Batteriesystem (50) nach einem der vorhergehenden Ansprüche, wobei die Strömungskanalschleife (73) mindestens ein Zellenfach (75), das zur Aufnahme mindestens eines Batteriemoduls (20) konfiguriert ist, und mindestens ein zusätzliches Fach (76) umfasst, das zur Aufnahme mindestens eines des Gasförderers (80) und des mindestens einen Gassensors (81) konfiguriert ist.

5. Batteriesystem (50) nach Anspruch 4, wobei mindestens ein Batteriemodul (20) in jedem Zellenfach (75) angeordnet ist, wobei einer des ersten und zweiten Modulanschlusses (21) in der Nähe eines Gaseinlasses (77) des Zellenfachs (75) und ein anderer des ersten und zweiten Modulanschlusses (22) in der Nähe eines Gasauslasses (78) des Zellenfachs (75) liegt.

6. Batteriesystem (50) nach Anspruch 4 oder 5, wobei eines des mindestens einen Zellenfachs (75a) über einen Gaseinlass (77a) mit einem Gasauslass (78b) eines benachbarten Zellenfachs (75b) oder des zusätzlichen Fachs (76) und über einen Gasauslass (78a) mit einem Gaseinlass (77b) eines benachbarten Zellenfachs (75b) oder des zusätzlichen Fachs (76) in Fluidverbindung steht.

7. Batteriesystem (50) nach einem der vorhergehenden Ansprüche, das eine Gassensoranordnung (81) mit einer Vielzahl von Gassensoren umfasst, wobei jeder Gassensor zum Erfassen einer Konzentration von mindestens einer Gasspezies im Gasstromkreislauf konfiguriert ist.

8. Batteriesystem (50) nach einem der vorhergehenden Ansprüche, das ferner ein Batteriemanagementsystem, BMS, (82) umfasst, das mit dem mindestens einen Gassensor (81) verbunden ist, wobei der mindestens eine Gassensor (81) so konfiguriert ist, dass er ein Steuersignal, CS, an das BMS (82) als Reaktion auf das Erfassen der überschüssigen Konzentration mindestens einer Gasspezies im Gasstromkreislauf (74) sendet.

9. Batteriesystem (50) nach Anspruch 8, das ferner eine Batterietrenneinheit, BDU, (83) umfasst, die zwischen mindestens einem des ersten und zweiten Systemanschlusses (51, 52) und dem mindestens einen Batteriemodul (20) angeschlossen ist, wobei das BMS (82) so konfiguriert ist, dass es ein Trennsignal, DS, an die BDU (83) als Reaktion auf den Empfang des Steuersignals, CS, überträgt, und wobei die BDU (83) konfiguriert ist, um die Verbindung zwischen dem ersten und/oder zweiten Systemanschluss (51, 52) und dem mindestens einen Batteriemodul (20) als Reaktion auf das Trennsignal, DS, zu trennen.

10. Batteriesystem (50) nach Anspruch 8, das ferner eine Vielzahl von Schwachstromverbindern (64) umfasst, die eine Datenverbindung zwischen dem mindestens einen Batteriemodul (20) und dem BMS (82) bilden und vollständig innerhalb der Strömungskanalschleife (73) angeordnet sind.

11. Batteriesystem (50) nach einem der vorhergehenden Ansprüche, wobei die Vielzahl von Hochstromverbindern (63) mindestens einen ersten HV-Verbinder (63a), der einen zweiten Systemanschluss (52) mit einem zweiten Modulanschluss (22) des mindestens einen Batteriemoduls (20) verbindet, und einen zweiten HV-Verbinder (63b), der einen ersten Systemanschluss (51) mit einem ersten Modulanschluss (21) des mindestens einen Batteriemoduls (20) verbindet, umfasst.

12. Batteriesystem (50) nach Anspruch 11, umfassend eine Vielzahl von Batteriemodulen (20a, 20b, 20c), die zwischen dem ersten Systemanschluss (51) und dem zweiten Systemanschluss (52) in Reihe geschaltet sind, und mindestens einen dritten HV-Verbinder (63c), der einen zweiten Modulanschluss (22a) eines ersten Batteriemoduls (20a) mit einem ersten Modulanschluss (21b) eines zweiten Batteriemoduls (20b) verbindet.

13. Elektrisches Fahrzeug, umfassend das Batteriesystem (50) nach einem der Ansprüche 1 bis 12.

14. Verfahren zum Erkennen einer abnormalen Bedingung eines Batteriesystems (50), das mindestens ein Batteriemodul (20), das zwischen einem ersten Systemanschluss (51) und einem zweiten Systemanschluss (52) durch eine Vielzahl von Hochstromverbindern (63) verbunden ist, ein Gehäuse (70) mit einer Vielzahl von Außenwänden (71), die das mindestens eine Batteriemodul (20) und die Vielzahl von Hochstromverbindern (63) umschließen, und mindestens eine Trennwand (72), die innerhalb des Gehäuses (70) angeordnet ist, umfasst, wobei das Verfahren die folgenden Schritte umfasst:
Fördern eines Gasstromkreislaufs (74) durch eine Strömungskanalschleife (73), die in dem Gehäuse (70) durch die Außenwände (71) und die mindestens eine Trennwand (72) ausgebildet ist,
Erkennen der Konzentration mindestens einer Gasspezies im Gasstromkreislauf (74),
Übertragen mindestens eines Steuersignals, CS, als Reaktion auf die Erkennung einer überschüssigen Konzentration mindestens einer Gasspezies,
wobei der Gasstromkreislauf (74) ausgebildet ist, um einem Hochstrompfad zu folgen, der durch die Vielzahl von Hochstromverbindern (63) und das mindestens eine Batteriemodul (20) zwischen dem ersten und zweiten Systemanschluss (51, 52) durch die mindestens eine Trennwand (72) gebildet wird.

15. Verfahren nach Anspruch 14, das außerdem die folgenden Schritte umfasst:
Bestimmen des Vorhandenseins mindestens einer abnormalen Bedingung im Batteriesystem (50),
Steuern mindestens einer Gegenmaßnahme für die vorliegende mindestens eine abnormale Bedingung.

## Revendications

1. Système de batterie (50), comprenant
au moins un module de batterie (20) interconnecté entre une première borne de système (51) et une deuxième borne de système (52) par une pluralité de connecteurs à haute intensité (63) ; et
un boîtier (70) ayant une pluralité de parois extérieures (71) enfermant l'au moins un module de batterie (20) et la pluralité de connecteurs à haute intensité (63) et ayant au moins une paroi de séparation (72) agencée à l'intérieur du boîtier (70) ;
dans lequel une boucle de canal d'écoulement (73) est formée à l'intérieur du boîtier (70) par l'au moins une paroi de séparation (72) et les parois extérieures (71),
dans lequel un convoyeur de gaz (80) configuré pour fournir une circulation de flux de gaz (74) à travers la boucle de canal d'écoulement (73) et au moins un capteur de gaz (81) configuré pour détecter une concentration excessive d'au moins une espèce de gaz dans la circulation de flux de gaz (74) sont agencés dans la boucle de canal d'écoulement (73), et
dans lequel la circulation de flux de gaz (74) est formée pour suivre un chemin à haute intensité constitué par la pluralité de connecteurs à haute intensité (63) et l'au moins un module de batterie (20) entre les première et deuxième bornes de système (51, 52) par l'au moins une paroi de séparation (72).

2. Système de batterie (50) selon la revendication 1, dans lequel l'au moins un module de batterie (20) et la pluralité de connecteurs à haute intensité (63) sont agencés entièrement à l'intérieur de la boucle de canal d'écoulement (73) .

3. Système de batterie (50) selon la revendication 1 ou 2, dans lequel la circulation de flux de gaz (74) circule autour de l'ensemble d'au moins un module de batterie (20), de l'ensemble de la pluralité de connecteurs à haute intensité (63) et de l'au moins un capteur de gaz (81).

4. Système de batterie (50) selon l'une quelconque des revendications précédentes, dans lequel la boucle de canal d'écoulement (73) comprend au moins un compartiment de cellule (75) configuré pour recevoir au moins un module de batterie (20) et au moins un compartiment supplémentaire (76) configuré pour recevoir au moins l'un du convoyeur de gaz (80) et de l'au moins un capteur de gaz (81).

5. Système de batterie (50) selon la revendication 4, dans lequel au moins un module de batterie (20) est disposé à l'intérieur de chaque compartiment de cellule (75) avec l'une d'une première et d'une deuxième borne (21) de module à proximité d'une entrée de gaz (77) du compartiment de cellule (75) et une autre des première et deuxième bornes de module (22) à proximité d'une sortie de gaz (78) du compartiment de cellule (75).

6. Système de batterie (50) selon la revendication 4 ou 5, dans lequel l'un des un ou plusieurs compartiments de cellule (75a) est relié de manière fluidique à une sortie de gaz (78b) d'un compartiment de cellule adjacent (75b) ou du compartiment supplémentaire (76) via une entrée de gaz (77a) et à une entrée de gaz (77b) d'un compartiment de cellule adjacent (75b) ou du compartiment supplémentaire (76) via une sortie de gaz (78a).

7. Système de batterie (50) selon l'une quelconque des revendications précédentes, comprenant un réseau de capteurs de gaz (81) ayant une pluralité de capteurs de gaz, dans lequel chaque capteur de gaz est configuré pour détecter une concentration d'au moins une espèce de gaz dans la circulation de flux de gaz.

8. Système de batterie (50) selon l'une quelconque des revendications précédentes, comprenant en outre un système de gestion de batterie, BMS, (82) connecté à l'au moins un capteur de gaz (81), dans lequel l'au moins un capteur de gaz (81) est configuré pour transmettre un signal de commande, CS, au BMS (82) en réponse à la détection de la concentration excessive d'au moins une espèce gazeuse dans la circulation de flux de gaz (74).

9. Système de batterie (50) selon la revendication 8, comprenant en outre une unité de déconnexion de batterie, BDU, (83) interconnectée entre au moins l'une des première et deuxième bornes de système (51, 52) et l'au moins un module de batterie (20), dans lequel le BMS (82) est configuré pour transmettre un signal de déconnexion, DS, à la BDU (83) en réponse à la réception du signal de commande, CS, et dans lequel la BDU (83) est configurée pour déconnecter au moins l'une des première et deuxième bornes de système (51, 52) et l'au moins un module de batterie (20) en réponse au signal de déconnexion, DS.

10. Système de batterie (50) selon la revendication 8, comprenant en outre une pluralité de connecteurs à faible intensité (64) constituant une connexion de données entre l'au moins un module de batterie (20) et le BMS (82) et étant agencés entièrement dans la boucle de canal d'écoulement (73) .

11. Système de batterie (50) selon l'une quelconque des revendications précédentes, dans lequel la pluralité de connecteurs à haute intensité (63) comprend au moins un premier connecteur HT (63a) interconnectant une deuxième borne de système (52) à une deuxième borne de module (22) de l'au moins un module de batterie (20) et un deuxième connecteur HT (63b) interconnectant une première borne de système (51) à une première borne de module (21) de l'au moins un module de batterie (20).

12. Système de batterie (50) selon la revendication 11, comprenant une pluralité de modules de batterie (20a, 20b, 20c) connectés en série entre la première borne de système (51) et la deuxième borne de système (52), et au moins un troisième connecteur HT (63c) interconnectant une deuxième borne de module (22a) d'un premier module de batterie (20a) à une première borne de module (21b) d'un deuxième module de batterie (20b).

13. Véhicule électrique comprenant le système de batterie (50) selon l'une quelconque des revendications 1 à 12.

14. Procédé de détection d'un état anormal d'un système de batterie (50) comprenant au moins un module de batterie (20) interconnecté entre une première borne de système (51) et une deuxième borne de système (52) par une pluralité de connecteurs à haute intensité (63), un boîtier (70) ayant une pluralité de parois extérieures (71) enfermant l'au moins un module de batterie (20) et la pluralité de connecteurs à haute intensité (63) et au moins une paroi de séparation (72) agencée à l'intérieur du boîtier (70), le procédé comprenant les étapes :
d'acheminement d'une circulation de flux de gaz (74) à travers une boucle de canal d'écoulement (73) formée dans le boîtier (70) par les parois extérieures (71) et l'au moins une paroi de séparation (72),
de détection d'une concentration d'au moins une espèce de gaz dans la circulation de flux de gaz (74),
de transmission d'au moins un signal de commande, CS, en réponse à la détection d'un excès de concentration d'au moins une espèce de gaz,
dans lequel la circulation de flux de gaz (74) est formée pour suivre un chemin à haute intensité constitué par la pluralité de connecteurs à haute intensité (63) et l'au moins un module de batterie (20) entre les première et deuxième bornes de système (51, 52) par l'au moins une paroi de séparation (72).

15. Procédé selon la revendication 14, comprend en outre les étapes :
de détermination de la présence d'au moins un état anormal dans le système de batterie (50),
de commande d'au moins une contre-mesure à la présence d'au moins un état anomal.
